# FASCICULE DE BREVET EUROPEEN

(11) **EP 4 392 798 B1**
(45) Date de publication et mention de la délivrance du brevet: **07.05.2025**
(21) Numéro de dépôt: 22741333.3
(22) Date de dépôt: 14.06.2022
(51) Int. Cl.: G01R 35/00, G01R 31/00, G01R 31/327

(54) **PROCEDE DE VERIFICATION D'UN DISPOSITIF DE TEST DE BATTERIE AUXILIAIRE**
VERFAHREN ZUR ÜBERPRÜFUNG EINER VORRICHTUNG ZUR PRÜFUNG EINER HILFSBATTERIE
METHOD FOR CHECKING A DEVICE FOR TESTING AN AUXILIARY BATTERY

(30) Priorité: 24.08.2021 FR 2108864
(43) Date de publication de la demande: 03.07.2024
(73) Titulaire: Stellantis Auto SAS, 78300 Poissy (FR)
(72) Inventeur: BOTCHON, Yannick, 92160 Antony (FR)
(74) Mandataire: PSIP
(86) Numéro de dépôt international: PCT/FR2022/051133
(87) Numéro de publication internationale: WO 2023/025994

(56) Documents cités:
- CN-A- 104 808 078
- CN-U- 202 522 653
- US-B2- 10 551 804
- "Zellspannungsemulation: Spannung garantiert Hochgenaue Zellspannungsemulation mit dem dSPACE HIL-Simulator", INTERNET CITATION, 1 March 2010 (2010-03-01), pages 40 - 45, XP002679139, Retrieved from the Internet <URL:http://www.dspace.com/shared/data/pdf/2011/dSPACE-Magazine-2010-03_Batterie_D.pdf> [retrieved on 20120627]

## Description

### DOMAINE TECHNIQUE DE L'INVENTION

L'invention concerne un procédé de vérification d'un dispositif de test de la capacité d'une batterie auxiliaire à alimenter en énergie électrique des organes sécuritaires d'un véhicule électrique, un dispositif de vérification du dispositif de test et un véhicule électrique comprenant un tel dispositif de vérification.

Un véhicule électrique comprend une série de batteries principales permettant d'alimenter un moteur électrique en énergie électrique pour déplacer le véhicule électrique et un producteur d'énergie électrique de 12 volts apte à alimenter un réseau de bord en 12 volts. Le producteur d'énergie électrique comprend un convertisseur de tension DCDC.

Lors de manœuvres dites sécuritaire (freinage d'urgence, évitement, par exemple) le producteur d'énergie électrique alimente les organes sécuritaires tels que l'ESP (de l'anglais « Electronic Stability Program ») ou la DAE (Direction Assistée Electrique) par exemple.

Le producteur d'énergie électrique comprend également une batterie auxiliaire de 12 volts communément appelée stockeur 12 volts.

Lors des manœuvres sécuritaire (freinage d'urgence, évitement) la batterie auxiliaire présente un rôle fondamental car elle doit garantir, en cas de défaillance du producteur d'énergie électrique, des niveaux de tensions minimums aux organes sécuritaires.

### ÉTAT DE LA TECHNIQUE ANTÉRIEURE

Pour cela, il existe un moyen de tester l'état de santé de la batterie auxiliaire au moyen d'une sollicitation préalable de la batterie auxiliaire, sous forme d'un ou plusieurs appels de courant successifs. Ceci permet d'évaluer des paramètres tels que la résistance interne et les tensions minimales de la batterie auxiliaire atteintes pendant le processus de test.

Ces sollicitations de la batterie auxiliaire peuvent être réalisées sur un véhicule électrique, en utilisant un dispositif de test permettant d'isoler la batterie auxiliaire du convertisseur de tension DCDC d'une part et de commuter une résistance ou charge électrique selon un profil d'activation défini.

Cependant, le dispositif de test peut être défaillant et échouer à commuter la résistance de test pour tester le dispositif de test vérifiant la capacité de la batterie auxiliaire à alimenter en énergie électrique les organes sécuritaires d'un véhicule électrique.

En outre, l'état de la technique est connu du document disponible sur Internet « Zellspannungsemulation ; Spannung garantiert Hochgenaue Zellspannungsemulation mit dem dSPACE HIL-Simulator », URL :http://www.dspace.com/shared/data/pdf/2011/dSPACE-magazine-2010-03_Batterie_D.pdf, ainsi que des documents US10551804B2, CN104808078A et CN202522653U.

### EXPOSE DE L'INVENTION

L'invention vise à remédier à tout ou partie des inconvénients de l'état de la technique en proposant notamment un procédé de vérification d'un dispositif de test de la capacité d'une batterie auxiliaire à alimenter en énergie électrique des organes sécuritaires d'un véhicule électrique, permettant d'assurer que le dispositif de test fonctionne correctement.

Pour ce faire, il est proposé un procédé de vérification d'un dispositif de test de la capacité d'une batterie auxiliaire à alimenter en énergie électrique des organes sécuritaires d'un véhicule électrique. Le dispositif de test comprend un disjoncteur électrique apte à commuter une résistance de test reliée à la batterie auxiliaire et met en œuvre une procédure de test T comprenant une étape A d'isolation de la batterie auxiliaire d'un convertisseur DCDC destiné à alimenter un système de bord du véhicule électrique en énergie électrique, et une étape B de commutation de la résistance de test pour permettre de générer des variations de courant au moyen de la batterie auxiliaire pour la tester.

Selon l'invention, le procédé de vérification comprend une étape C de comptage du nombre d'échecs N à commuter la résistance de test, une étape D de détermination du niveau de risque à échouer la commutation de la résistance de test en fonction du nombre d'échecs N, et une étape E d'alerte de l'utilisateur en fonction du niveau de risque déterminé.

Selon un mode de réalisation, le procédé de vérification comprend une étape F de traitement des données défaillantes responsables du niveau de risque déterminé lorsqu'un niveau de risque est déterminé.

De préférence, lors de l'étape C, le nombre d'échecs N est incrémenté de 1 si le véhicule électrique est à l'arrêt et si un échec à commuter la résistance de test a été détecté.

Selon une variante, le nombre d'échecs N est réinitialisé à zéro si la commutation de la résistance de test est un succès lorsque le véhicule électrique roule ou si la commutation de la résistance de test est un succès avant la mise sous tension du véhicule électrique.

Selon un autre mode de réalisation, l'étape D comprend un premier niveau de risque à échouer la commutation de la résistance de test et un deuxième niveau de risque à échouer la commutation de la résistance de test. Les niveaux de risque sont déterminés en fonction d'un premier seuil S1 de nombre d'échecs N successifs à commuter la résistance de test et d'un deuxième seuil S2 de nombre d'échecs N successifs à commuter la résistance de test.

De préférence, le premier niveau de risque est atteint lorsque le nombre d'échecs N successifs à commuter la résistance de test est supérieur ou égal à S1 et inférieur à S2. Le deuxième niveau de risque est atteint lorsque le nombre d'échecs N successifs à commuter la résistance de test est supérieur à S2.

Avantageusement, aucun risque n'est détecté lorsque le premier niveau de risque est atteint et si le nombre d'échecs N à commuter la résistance de test est à zéro ou lorsque le deuxième niveau de risque est atteint et si le nombre d'échecs N à commuter la résistance de test est à zéro lors de la mise sous tension du véhicule électrique avant son démarrage ou lorsque le deuxième niveau de risque est atteint et si le véhicule électrique est sous tension avant d'être démarré et que le nombre d'échecs N est réinitialisé à zéro.

Selon un mode de réalisation, l'étape E comprend un premier niveau d'alerte de l'utilisateur lorsque le premier niveau de risque est atteint et un deuxième niveau d'alerte de l'utilisateur lorsque le deuxième niveau de risque est atteint.

L'invention fournit ainsi un procédé de vérification d'un dispositif de test de la capacité d'une batterie auxiliaire à alimenter en énergie électrique des organes sécuritaires d'un véhicule électrique, permettant d'assurer que le dispositif de test fonctionne correctement.

Plus particulièrement, la présente invention permet de vérifier que la résistance de test ou de diagnostic du disjoncteur du dispositif de test commute correctement afin de permettre de générer des variations de courant au niveau de la batterie auxiliaire pour la tester.

La connaissance de l'état de la batterie auxiliaire, grâce au résultat de la procédure de test et du niveau d'exposition au risque de défaillance du test, permet par la suite d'adapter la gestion électrique du réseau de bord 12 volts du véhicule électrique, en réduisant la consommation électrique globale, ou encore d'alerter l'utilisateur au moyen de voyants et de systèmes d'information dédiés.

La sécurisation du réseau de bord 12 volts est ainsi améliorée et à moindre coût.

De plus, les analyses réalisées lors de l'étape F de traitement des données défaillantes permettent à des équipes de développement de traiter les éventuelles survenus de crises et d'améliorer la conception du système de bord 12 volts du véhicule électrique.

L'invention concerne également un dispositif de vérification d'un dispositif de test de la capacité d'une batterie auxiliaire à alimenter en énergie électrique des organes sécuritaires d'un véhicule électrique.

Selon l'invention, il met en œuvre le procédé de vérification tel que défini précédemment. Le dispositif de test comprend un disjoncteur électrique apte à commuter une résistance de test reliée à la batterie auxiliaire pour permettre de générer des variations de courant au moyen de la batterie auxiliaire pour la tester.

L'invention concerne également un véhicule électrique comprenant un dispositif de vérification d'un dispositif de test de la capacité d'une batterie auxiliaire à alimenter en énergie électrique des organes sécuritaires d'un véhicule électrique tel que défini précédemment.

### BRÈVE DESCRIPTION DES FIGURES

D'autres caractéristiques et avantages de l'invention ressortiront à la lecture de la description qui suit, en référence à la figure annexée, qui illustre :

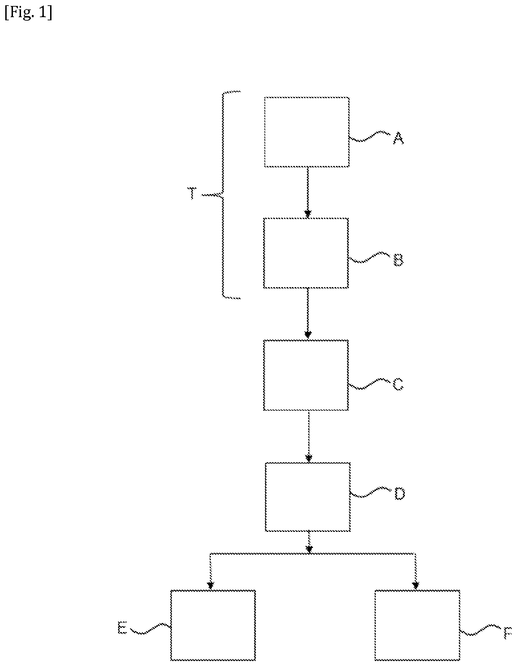

[Fig. 1] : un logigramme d'un procédé de vérification d'un dispositif de test de la capacité d'une batterie auxiliaire à alimenter en énergie électrique des organes sécuritaires d'un véhicule électrique, selon l'invention.

### DESCRIPTION DÉTAILLÉE D'UN MODE DE RÉALISATION

La figure 1 ([Fig. 1]) illustre un logigramme d'un procédé de vérification d'un dispositif de test de la capacité d'une batterie auxiliaire à alimenter en énergie électrique des organes sécuritaires d'un véhicule électrique, selon l'invention.

Le véhicule électrique comprend un producteur d'énergie électrique destiné à alimenter en énergie électrique un système de bord du véhicule électrique qui peut présenter une tension de 12 volts. Le producteur d'énergie électrique comprend un convertisseur de tension DCDC et une batterie auxiliaire apte à être isolée du convertisseur DCDC.

Le dispositif de test comprend un disjoncteur électrique apte à commuter une résistance de test pour générer des variations de courant au moyen de la batterie auxiliaire pour la tester.

De préférence, la batterie auxiliaire présente une tension de 12 volts. Le procédé de vérification s'applique également pour des batteries présentant des tensions différentes telles que comprises entre 10 volts et 15 volts, par exemple.

Le procédé de vérification comprend une procédure de test T comprenant une étape A d'isolation de la batterie auxiliaire du convertisseur DCDC et une étape B de commutation d'une résistance de test pour permettre de générer des variations de courant au moyen de la batterie auxiliaire pour la tester.

L'étape B de commutation peut être réalisée au moyen d'un ou plusieurs interrupteurs ou disjoncteurs utilisant des composants Mosfet (de l'anglais « Metal Oxide Semiconductor Field Effect Transistor »), par exemple.

Pour réaliser le test de la batterie auxiliaire, l'interrupteur commute selon deux positions (ouvert ou fermé). Le test sur la capacité du dispositif de test à commuter la résistance de test peut être basé sur une mesure des courants de fuite, au niveau de l'interrupteur, de façon à détecter une incapacité des composants Mosfets à commuter.

Le dispositif de test permettant de commuter la résistance de test informe ainsi sur la capacité de commutation.

Selon l'invention, le procédé de vérification comprend une étape C de comptage du nombre d'échecs N à commuter la résistance de test.

Lors de l'étape C, le nombre d'échecs N est incrémenté de 1 si le véhicule électrique est à l'arrêt et si un échec à commuter la résistance de test a été détecté.

Le dispositif de vérification comprend un compteur de supervision des échecs de test de capacité qui est incrémenté de 1 à chaque échec.

Le procédé réalise ainsi un cumul du nombre d'échecs successifs en fonction de l'état du véhicule électrique (à l'arrêt ou en roulage).

Le nombre d'échecs N est réinitialisé à zéro si la commutation de la résistance de test est un succès lorsque le véhicule électrique roule. Le dispositif de test retrouve alors sa capacité de commutation de la résistance de test en cours de roulage du véhicule électrique.

Le nombre d'échecs N est également réinitialisé à zéro si la commutation de la résistance de test est un succès avant la mise sous tension du véhicule électrique. C'est le cas lorsque le dispositif de test communique dès sa mise en service une capacité à pouvoir commuter et que l'utilisateur met le véhicule sous tension.

Dans ces deux cas de figure, la condition d'obtention des échecs successifs n'est pas réalisée.

Le procédé de vérification comprend, après l'étape C, une étape D de détermination du niveau de risque à échouer la commutation de la résistance de test en fonction du nombre d'échecs N.

Cette étape D détermine différents niveaux de risques liés aux nombres d'échecs N successifs à commuter la résistance de test.

Selon un mode de réalisation possible, l'étape D comprend un premier niveau de risque à échouer la commutation de la résistance de test et un deuxième niveau de risque à échouer la commutation de la résistance de test. Les niveaux de risque sont déterminés en fonction d'un premier seuil S1 de nombre d'échecs N successifs à commuter la résistance de test et d'un deuxième seuil S2 de nombre d'échecs N successifs à commuter la résistance de test.

Le premier niveau de risque est atteint lorsque le nombre d'échecs N successifs à commuter la résistance de test est supérieur ou égal à S1 et inférieur à S2. Le deuxième niveau de risque est atteint lorsque le nombre d'échecs N successifs à commuter la résistance de test est supérieur à S2.

Par exemple, le premier seuil S1 peut être égal à 1 et le deuxième seuil S2 peut être égal à 10.

Aucun risque n'est détecté lorsque le premier niveau de risque est atteint et si le nombre d'échecs N à commuter la résistance de test est à zéro.

De même, aucun risque n'est détecté lorsque le deuxième niveau de risque est atteint et si le nombre d'échecs N à commuter la résistance de test est à zéro lors de la mise sous tension du véhicule électrique avant son démarrage.

De même, aucun risque n'est détecté lorsque le deuxième niveau de risque est atteint et si le véhicule électrique est sous tension avant d'être démarré et que le nombre d'échecs N est réinitialisé à zéro.

Les niveaux de risque sont ensuite utilisés pour gérer des niveaux d'alerte différents. Ils permettent d'alerter l'utilisateur, lorsqu'un risque est avéré, sur la capacité du dispositif de test à commuter la résistance de test permettant de tester la batterie auxiliaire.

Le procédé de vérification comprend donc, après l'étape D, une étape E d'alerte de l'utilisateur en fonction du niveau de risque déterminé.

L'étape E comprend un premier niveau d'alerte de l'utilisateur lorsque le premier niveau de risque est atteint et un deuxième niveau d'alerte de l'utilisateur lorsque le deuxième niveau de risque est atteint.

Le premier niveau d'alerte peut être un niveau d'alerte maximal et le deuxième niveau d'alerte peut être un niveau d'alerte intermédiaire.

Le premier niveau d'alerte est émis lorsque le procédé de vérification détermine que le risque de ne pas pouvoir tester la batterie auxiliaire, via la commutation de la résistance de test, est élevé.

L'utilisateur est informé par un voyant de batterie auxiliaire qui reste allumé de façon fixe. Ceci informe l'utilisateur de faire examiner son réseau de bord 12 volts en service après-vente et notamment de faire vérifier le dispositif de test.

L'utilisateur peut être optionnellement informé par l'activation d'une IHM (Interface Homme-Machine) lui demandant de ne pas utiliser son véhicule.

Le deuxième niveau d'alerte est émis lorsque le procédé de vérification détermine que le risque de ne pas pouvoir tester la batterie auxiliaire, via la commutation de la résistance de test, est moyen.

L'utilisateur est informé par l'activation d'un voyant de service et éventuellement par une IHM lui indiquant de faire vérifier son réseau de bord 12 volts dans X roulages.

Dans le cas du premier niveau d'alerte, le voyant de batterie auxiliaire est éteint, le voyant d'arrêt du véhicule est éteint, le voyant de service est éteint et un message d'alerte informant de ne pas utiliser le véhicule est émis.

Dans le cas du deuxième niveau d'alerte, le voyant de batterie auxiliaire est allumé de façon fixe, le voyant d'arrêt du véhicule est éteint, le voyant de service est allumé et un message d'alerte informant que le véhicule ne pourra pas démarrer dans X cycle est émis.

Le procédé de vérification comprend, parallèlement à l'étape E, une étape F de traitement des données défaillantes responsables du niveau de risque déterminé lorsqu'un niveau de risque est déterminé.

L'étape F comprend une étape de transfert du nombre d'échecs N à commuter la résistance de test à au moins un serveur distant, une étape de stockage du nombre d'échecs N et une étape d'analyse du nombre d'échecs N.

L'étape de transfert est réalisée vers un ou plusieurs serveurs au moyen d'un dispositif sécurisé de communication à distance (réseau du type LTE par exemple), dès lors que le premier ou le deuxième niveau d'alerte est déterminé.

Cela permet de stocker le nombre d'échecs N sur des moyens de stockage pour réaliser des analyses de masse sur les types et l'occurrence des défauts.

Ces analyses permettent à des équipes de développement de traiter les éventuelles survenues de crises et d'améliorer la conception du système de bord 12 volts du véhicule électrique.

Lorsque le procédé de vérification du dispositif de test est terminé, la capacité de la batterie auxiliaire à pouvoir fournir la puissance nécessaire aux organes sécuritaires du véhicule électrique tels que la DAE et l'ESP, par exemple, est contrôlée lors de la procédure de test T.

La procédure de test T peut comprendre l'évaluation de paramètres tels que la résistance interne et les tensions minimales de la batterie auxiliaire atteintes pendant la procédure de test.

Naturellement, l'invention est décrite dans ce qui précède à titre d'exemple. Il est entendu que l'homme du métier est à même de réaliser différentes variantes de réalisation de l'invention sans pour autant sortir du cadre de l'invention.

Il est souligné que toutes les caractéristiques, telles qu'elles se dégagent pour un homme du métier à partir de la présente description, des dessins et des revendications attachées, même si concrètement elles n'ont été décrites qu'en relation avec d'autres caractéristiques déterminées, tant individuellement que dans des combinaisons quelconques, peuvent être combinées à d'autres caractéristiques ou groupes de caractéristiques divulguées ici, pour autant que cela n'a pas été expressément exclu ou que des circonstances techniques rendent de telles combinaisons impossibles ou dénuées de sens.

## Revendications

1. Procédé de vérification d'un dispositif de test de la capacité d'une batterie auxiliaire à alimenter en énergie électrique des organes sécuritaires d'un véhicule électrique, le dispositif de test comprenant un disjoncteur électrique apte à commuter une résistance de test reliée à la batterie auxiliaire et mettant en œuvre une procédure de test (T) comprenant :
- une étape (A) d'isolation de la batterie auxiliaire d'un convertisseur DCDC destiné à alimenter un système de bord du véhicule électrique en énergie électrique, et
- une étape (B) de commutation de la résistance de test pour permettre de générer des variations de courant au moyen de la batterie auxiliaire pour la tester,
**caractérisé en ce qu'**il comprend :
- une étape (C) de comptage du nombre d'échecs N à commuter la résistance de test,
- une étape (D) de détermination du niveau de risque à échouer la commutation de la résistance de test en fonction du nombre d'échecs N, et
- une étape (E) d'alerte de l'utilisateur en fonction du niveau de risque déterminé.

2. Procédé de vérification selon la revendication 1, **caractérisé en ce qu'**il comprend une étape (F) de traitement des données défaillantes responsables du niveau de risque déterminé lorsqu'un niveau de risque est déterminé.

3. Procédé de vérification selon l'une quelconques des revendications 1 ou 2, **caractérisé en ce que**, lors de l'étape (C), le nombre d'échecs N est incrémenté de 1 si le véhicule électrique est à l'arrêt et si un échec à commuter la résistance de test a été détecté.

4. Procédé de vérification selon la revendication 3, **caractérisé en ce que** le nombre d'échecs N est réinitialisé à zéro si la commutation de la résistance de test est un succès lorsque le véhicule électrique roule ou si la commutation de la résistance de test est un succès avant la mise sous tension du véhicule électrique.

5. Procédé de vérification selon l'une quelconques des revendications 1 à 4, **caractérisé en ce que** l'étape (D) comprend un premier niveau de risque à échouer la commutation de la résistance de test et un deuxième niveau de risque à échouer la commutation de la résistance de test, les niveaux de risque étant déterminés en fonction d'un premier seuil S1 de nombre d'échecs N successifs à commuter la résistance de test et d'un deuxième seuil S2 de nombre d'échecs N successifs à commuter la résistance de test.

6. Procédé de vérification selon la revendication 5, **caractérisé en ce que** le premier niveau de risque est atteint lorsque le nombre d'échecs N successifs à commuter la résistance de test est supérieur ou égal à S1 et inférieur à S2, le deuxième niveau de risque étant atteint lorsque le nombre d'échecs N successifs à commuter la résistance de test est supérieur à S2.

7. Procédé de vérification selon la revendication 6, **caractérisé en ce qu'**aucun risque n'est détecté lorsque le premier niveau de risque est atteint et si le nombre d'échecs N à commuter la résistance de test est à zéro ou lorsque le deuxième niveau de risque est atteint et si le nombre d'échecs N à commuter la résistance de test est à zéro et lors de la mise sous tension du véhicule électrique avant son démarrage ou lorsque le deuxième niveau de risque est atteint lors de la mise sous tension du véhicule électrique avant son démarrage et que le nombre d'échecs N est réinitialisé à zéro.

8. Procédé de vérification selon l'une quelconques des revendications 5 à 7, **caractérisé en ce que** l'étape (E) comprend un premier niveau d'alerte de l'utilisateur lorsque le premier niveau de risque est atteint et un deuxième niveau d'alerte de l'utilisateur lorsque le deuxième niveau de risque est atteint.

9. Dispositif de vérification d'un dispositif de test de la capacité d'une batterie auxiliaire à alimenter en énergie électrique des organes sécuritaires d'un véhicule électrique, **caractérisé en ce qu'**il met en œuvre le procédé de vérification tel que défini selon l'une quelconques des revendications 1 à 8, le dispositif de test comprenant un disjoncteur électrique apte à commuter une résistance de test reliée à la batterie auxiliaire pour permettre de générer des variations de courant au moyen de la batterie auxiliaire pour la tester.

10. Véhicule électrique, **caractérisé en ce qu'**il comprend un dispositif de vérification d'un dispositif de test de la capacité d'une batterie auxiliaire à alimenter en énergie électrique des organes sécuritaires d'un véhicule électrique tel que défini selon la revendication 9.

## Patentansprüche

1. Verfahren zum Überprüfen einer Vorrichtung zum Testen der Kapazität einer Zusatzbatterie, Sicherheitskomponenten eines Elektrofahrzeugs mit elektrischer Energie zu versorgen , wobei die Testvorrichtung einen elektrischen Leistungsschalter umfasst, der einen mit der Zusatzbatterie verbundenen Testwiderstand schalten kann, und ein Testverfahren (T) durchführt, das umfasst:
- einen Schritt (A) des Isolierens der Hilfsbatterie von einem DCDC-Wandler, der dazu bestimmt ist, ein Bordsystem des Elektrofahrzeugs mit elektrischer Energie zu versorgen, und
- ein Schritt (B) von Schalten des Prüfwiderstandes, um mittels der Hilfsbatterie Stromschwankungen zu deren Prüfung erzeugen zu können,
**dadurch gekennzeichnet, dass** es umfasst:
- einen Schritt (C) zum Zählen der Anzahl der Fehler N beim Umschalten des Prüfwiderstandes ,
- einen Schritt (D) zum Bestimmen des Risikoniveaus eines Fehlschlagens des Schaltens des Prüfwiderstands als Funktion der Anzahl der Fehlschläge N, und
- einen Schritt (E) zum Warnen des Benutzers entsprechend der ermittelten Risikostufe.

2. Überprüfungsverfahren nach Anspruch 1, **dadurch gekennzeichnet, dass** es einen Schritt (F) zum Verarbeiten der fehlerhaften Daten umfasst, die für das ermittelte Risikoniveau verantwortlich sind , wenn ein Risikoniveau ermittelt wird.

3. Überprüfungsverfahren nach einem der Ansprüche 1 oder 2, **dadurch gekennzeichnet, dass** während des Schritts (C) die Anzahl der Fehler N um 1 erhöht wird, wenn das Elektrofahrzeug steht und ein Fehler beim Schalten des Prüfwiderstands erkannt wurde.

4. Verifizierungsverfahren nach Anspruch 3, **dadurch gekennzeichnet, dass** die Anzahl der Fehler N wird auf Null zurückgesetzt, wenn die Umschaltung des Testwiderstands während der Fahrt des Elektrofahrzeugs erfolgreich ist oder wenn die Umschaltung des Testwiderstands vor dem Einschalten des Elektrofahrzeugs erfolgreich ist.

5. Überprüfungsverfahren nach einem der Ansprüche 1 bis 4, **dadurch gekennzeichnet, dass** Schritt (D) eine erste Risikostufe für das Fehlschlagen des Umschaltens des Prüfwiderstands umfasst. und eine zweite Risikostufe des Fehlschlagens beim Schalten des Prüfwiderstands, wobei die Risikostufen auf der Grundlage eines ersten Schwellenwerts S1 der Anzahl aufeinanderfolgender Fehlschläge N beim Schalten des Prüfwiderstands und eines zweiten Schwellenwerts S2 der Anzahl aufeinanderfolgender Fehlschläge N beim Schalten des Prüfwiderstands bestimmt werden.

6. Überprüfungsverfahren nach Anspruch 5, **dadurch gekennzeichnet, dass** die erste Risikostufe erreicht wird , wenn die Anzahl der aufeinanderfolgenden Fehler N beim Schalten des Prüfwiderstands größer oder gleich S1 und kleiner als S2 ist, wobei die zweite Risikostufe erreicht wird, wenn die Anzahl der aufeinanderfolgenden Fehler N beim Schalten des Prüfwiderstands größer als S2 ist.

7. Überprüfungsverfahren nach Anspruch 6, **dadurch gekennzeichnet, dass** kein Risiko erkannt wird, wenn die erste Risikostufe erreicht ist und die Anzahl der Fehler N beim Schalten des Prüfwiderstandes Null ist oder wenn die zweite Risikostufe erreicht ist. und wenn die Anzahl der Fehlschläge N beim Einschalten des Prüfwiderstandes Null ist und beim Einschalten des Elektrofahrzeugs vor dem Starten oder wenn beim Einschalten des Elektrofahrzeugs vor dem Starten die zweite Risikostufe erreicht wird und die Anzahl der Ausfälle N auf Null zurückgesetzt wird.

8. Überprüfungsverfahren nach einem der Ansprüche 5 bis 7, **dadurch gekennzeichnet, dass** Schritt (E) eine erste Ebene umfasst Eine Benutzerwarnung wird ausgegeben , wenn die erste Risikostufe erreicht wird, und eine zweite Benutzerwarnung, wenn die zweite Risikostufe erreicht wird.

9. Gerät zur Überprüfung einer Vorrichtung zum Testen der Kapazität einer Hilfsbatterie zur Versorgung von Sicherheitskomponenten eines Elektrofahrzeugs mit elektrischer Energie, **dadurch gekennzeichnet, dass** sie das Überprüfungsverfahren gemäß einem der Ansprüche 1 bis 8 implementiert, wobei die Englisch : www.wintershall.com/224.html?&L=11 Eine Testvorrichtung mit einem elektrischen Schutzschalter , der einen an die Hilfsbatterie angeschlossenen Testwiderstand schalten kann , um durch die Hilfsbatterie Stromschwankungen zu erzeugen und diese zu testen .

10. Elektrofahrzeug, **dadurch gekennzeichnet, dass** es eine Vorrichtung umfasst zur Überprüfung einer Vorrichtung zum Testen der Kapazität einer Zusatzbatterie zur Versorgung von Sicherheitskomponenten eines Elektrofahrzeugs mit elektrischer Energie, wie in Anspruch 9 definiert.

## Claims

1. Method for verifying a device for testing the capacity of an auxiliary battery to supply electrical energy to safety components of an electric vehicle , the test device comprising an electrical circuit breaker capable of switching a test resistor connected to the auxiliary battery and implementing a test procedure (T) comprising:
- a step (A) of isolating the auxiliary battery from a DCDC converter intended to supply an on-board system of the electric vehicle with electrical energy, and
- a step (B) of switching the test resistor to enable current variations to be generated by means of the auxiliary battery for testing it,
**characterized in that** it comprises:
- a step (C) of counting the number of failures N to switch the test resistor ,
- a step (D) of determining the level of risk of failing the switching of the test resistor as a function of the number of failures N, and
- a step (E) of alerting the user according to the level of risk determined.

2. Verification method according to claim 1, **characterized in that** it comprises a step (F) of processing the faulty data responsible for the level of risk determined when a level of risk is determined.

3. Verification method according to any one of claims 1 or 2, **characterized in that**, during step (C), the number of failures N is incremented by 1 if the electric vehicle is stationary and if a failure to switch the test resistor has been detected.

4. method according to claim 3, **characterized in that** the number of failures N is reset to zero if the test resistor switching is successful while the electric vehicle is driving or if the test resistor switching is successful before the electric vehicle is powered on.

5. Verification method according to any one of claims 1 to 4, **characterized in that** step (D) comprises a first level of risk of failing the switching of the test resistor. and a second risk level of failing to switch the test resistor, the risk levels being determined based on a first threshold S1 of the number of successive failures N to switch the test resistor and a second threshold S2 of the number of successive failures N to switch the test resistor.

6. Verification method according to claim 5, **characterized in that** the first risk level is reached when the number of successive failures N to switch the test resistor is greater than or equal to S1 and less than S2, the second risk level being reached when the number of successive failures N to switch the test resistor is greater than S2 .

7. Verification method according to claim 6, **characterized in that** no risk is detected when the first risk level is reached and if the number of failures N to switch the test resistor is zero or when the second risk level is reached. and if the number of failures N to switch the test resistor is zero and when switching on the electric vehicle before starting it or when the second risk level is reached when switching on the electric vehicle before starting it and the number of failures N is reset to zero.

8. Verification method according to any one of claims 5 to 7, **characterized in that** step (E) comprises a first level user alert when the first risk level is reached and a second user alert when the second risk level is reached.

9. Device for verifying a device for testing the capacity of an auxiliary battery to supply electrical energy to safety components of an electric vehicle, **characterized in that** it implements the verification method as defined according to any one of claims 1 to 8, the test device comprising an electrical circuit breaker capable of switching a test resistor connected to the auxiliary battery to enable current variations to be generated by means of the auxiliary battery to test it.

10. Electric vehicle, **characterized in that** it comprises a device for verifying a device for testing the capacity of an auxiliary battery to supply electrical energy to safety components of an electric vehicle as defined according to claim 9.
